Europäisches Patentamt

(19) European Patent Office

Office européen des brevets

(11) Numéro de publication : **0 261 190 B1**

(12) **FASCICULE DE BREVET EUROPEEN**

(45) Date de publication du fascicule du brevet :
17.07.91 Bulletin 91/29

(51) Int. Cl.⁵ : **H01L 21/314, H01L 21/324**

(21) Numéro de dépôt : **87902106.1**

(22) Date de dépôt : **25.03.87**

(86) Numéro de dépôt international :
**PCT/FR87/00093**

(87) Numéro de publication internationale :
**WO 87/06058 08.10.87 Gazette 87/22**

(54) **PROCEDE DE PASSIVATION EN SURFACE D'UN SUBSTRAT EN PHOSPHURE D'INDIUM ET PRODUIT NOUVEAU OBTENU.**

(30) Priorité : 27.03.86 FR 8604647

(43) Date de publication de la demande :
30.03.88 Bulletin 88/13

(45) Mention de la délivrance du brevet :
17.07.91 Bulletin 91/29

(84) Etats contractants désignés :
DE GB NL

(56) Documents cités :
EP-A- 0 132 326
Applied Physics Letters, vol. 48, no. 7,
February 1986 (New York, USA), M. Sacilotti et
al.: "Stabilization of InP substrate under
annealing in the presence of GaAs", pages
481-483
Applied Physics Letters, vol. 46, no. 8, April
1985 (American Institute of Physics, New York,
USA), R. Blanchet et al.: "Reduction of fast
interface states and suppression of drift phenomena in arsenic-stabilized metal-insula-
tor-InP structures", pages 761-763

(73) Titulaire : **ECOLE CENTRALE DE LYON**
**36, avenue Guy de Collonge B.P. 163**
**F-69131 Ecully Cédex (FR)**

(72) Inventeur : **BLANCHET, Robert, Charles,**
**Fernand**
**82, avenue de la Poterie**
**F-69890 La Tour de Salvagny (FR)**
Inventeur : **CHOUJAA, Abdelkrim**
**Ecole Centrale de Lyon 36, avenue Guy de**
**Collonge**
**B.P. 163 F-69131 Ecully Cédex (FR)**
Inventeur : **CHAVE, Jacques, Philippe, Paul**
**14, rue Professeur Galtier**
**F-69100 Villeurbanne (FR)**
Inventeur : **VIKTOROVITCH, Pierre**
**18, avenue Gambetta**
**F-69160 Tassin la Demi Lune (FR)**

(74) Mandataire : **Ropital-Bonvarlet, Claude**
**Cabinet BEAU DE LOMENIE, 51, avenue**
**Jean-Jaurès**
**F-69007 Lyon (FR)**

**Description**

## DOMAINE TECHNIQUE :

La présente invention concerne le domaine technique de la fabrication de composants électroniques et opto-électroniques, tels que les diodes, les composants MIS (métal-isolant-semiconducteur) et elle vise, plus particulièrement, celui de la fabrication de tels composants à base de phosphure d'indium en tant que semiconducteur.

Des composants électroniques d'un tel type ont déjà été produits et utilisés avec plus ou moins de succès. On a constaté, en effet, que le fonctionnement de tels composants est largement dépendant des propriétés de surface et d'interface entre la couche semiconductrice et la couche isolante. Ceci semble lié au procédé d'obtention d'un substrat en phosphure d'indium, faisant intervenir initialement un découpage mécanique ou autre à partir d'un barreau monocristallin, puis, ensuite, un polissage de la face destinée à être revêtue de la couche isolante, aux caractéristiques physico-chimiques du phosphure d'indium et au procédé d'obtention de la couche isolante.

De telles plaques possèdent, en effet, des défauts de surface résultant de défauts chimiques ou structurels qui se conduisent comme des pièges donneurs ou accepteurs d'électrons s'opposant ou perturbant le fonctionnement d'une structure électronique.

Pour remédier à cet inconvénient, il vient à l'esprit de compenser les défauts de surface du substrat semiconducteur.

Pour compenser de tels défauts, il n'est toutefois pas envisageable de déposer en surface un oxyde de phosphore ou d'indium, car il en existe un grand nombre qui sont tous, soit volatils, soit instables et sont donc générateurs aussi de défauts de surface qu'on cherche justement à compenser.

## TECHNIQUE ANTERIEURE :

Pour tenter d'apporter une solution à ce problème, la technique antérieure a proposé différentes méthodes de traitement.

L'une d'elles, divulguée par la revue APPLIED PHYSICS LETTERS, volume 46 n° 4, pages 416 à 418 (15.02.85), consiste à faire croître sur la surface à traiter d'un substrat en phosphure d'indium une couche isolante composée d'un oxynitrure de phosphore destinée à compenser les défauts de surface, elle même recouverte d'une seconde couche isolante (silice) compliquant la fabrication et conférant aux composants des propriétés d'instabilité.

Par ailleurs, pour guérir les défauts, l'oxynitrure doit être de composition bien définie, ce qui est difficile à reproduire pour un corps comme l'oxynitrure de phosphore dont la teneur en phosphore, azote et oxygène est éminemment variable.

Une seconde méthode connue, divulguée par la revue IEEE, TRANSACTIONS ON ELECTRON DEVICES, volume ED 31 n° 8, pages 1038 à 1043 (1984), consiste en une oxydation anodique d'une couche d'aluminium prédéposée, l'oxydation anodique étant prolongée de telle façon qu'un oxyde riche en phosphore se constitue à l'interface InP-alumine. Une telle technique conduit à un diélectrique double couche susceptible de provoquer des dérives des caractéristiques de fonctionnement d'un composant réalisé à partir de cette technique, d'autant plus que l'oxyde de phosphore est instable. Par ailleurs, une telle méthode ne peut être envisagée facilement pour la fabrication de diodes.

Une troisième méthode, préconisée par la revue JAPANESE JOURNAL OF APPLIED PHYSICS, volume 23 n° 8, pages 1157 et 1158 (1984), consiste à déposer un oxynitrure de phosphore qui constitue en entier l'isolant de grille. Une difficulté de reproductibilité de la composition de cet oxynitrure et la difficulté de le graver chimiquement constituent les inconvénients majeurs de cette méthode.

Une quatrième méthode, enseignée par la publication ELECTRONICS LETTERS, volume 19 n° 13, pages 459 à 461 (1983), consiste à placer le substrat de phosphure d'indium dans une ampoule scellée contenant du soufre. L'ampoule est chauffée pour produire, par sulfuration, une couche isolante qui se décompose en provoquant une perte de phosphore et qui nécessite d'être recouverte par une deuxième couche isolante pour limiter les courants de fuite. Les composants obtenus sont instables.

Une cinquième méthode, due aux travaux des inventeurs publiée dans la revue APPLIED PHYSICS LETTERS, volume 46 n° 8, pages 761 à 763 (1485), consiste à placer le substrat en phosphure d'indium dans une enceinte sous ultra-vide avec présence d'arsenic sous pression partielle. Cette technique, fondée sur l'aptitude de l'arsenic à améliorer la stabilité chimique et les propriétés électroniques du phosphure d'indium en compensant probablement les lacunes de phosphore, permet l'obtention d'un état de surface passivé apte à recevoir tout dépôt ultérieur.

Une telle méthode fait intervenir une montée en température supérieure à 500°C et ne peut donc être retenue dans le cas de substrats déjà en partie élaborés, à moins de faire intervenir un procédé de traitement beaucoup plus complexe et très coûteux consistant, notamment, à masquer certaines parties des substrats avec un produit résistant au traitement, tel que le tantale.

Une telle méthode implique l'établissement d'un vide poussé, ce qui conduit à la mise en oeuvre d'un matériel lourd, complexe et coûteux exigeant un personnel hautement qualifié.

Ainsi, aucune des méthodes connues n'apparaît donc susceptible d'être retenue pour produire, de façon simple, certaine et relativement peu onéreuse, un substrat de phosphure d'indium possédant un état de surface capable de fournir, une fois revêtu d'une couche isolante, des caractéristiques électriques acceptables et constantes dans le temps pour la production industrielle de composants électroniques performants.

## EXPOSE DE L'INVENTION :

L'objet de l'invention est de résoudre le problème ainsi posé en préconisant un procédé de passivation de surface de substrats en phosphure d'indium aptes à être utilisés pour la fabrication de composants électroniques ou opto-électroniques divers, tels que des structures MIS, des diodes, dispositifs à transfert de charges, etc...

L'objectif de l'invention est de proposer un nouveau procédé particulièrement simple, ne nécessitant pas d'installation industrielle complexe et coûteuse et pouvant être conduit sans risque par un personnel non spécialement hautement qualifié.

Pour atteindre cet objectif, le procédé de l'invention est caractérisé en ce qu'il consiste à :
- soumettre le substrat à un dégraissage sans application d'ultrasons,
- tremper, pendant une durée comprise entre 30 secondes et 10 minutes, le substrat dans une solution aqueuse d'ions complexes d'arsenic, de pH inférieur à 4 et maintenue à une température comprise entre 0 et 50°C,
- rincer abondamment le substrat à l'eau desionisée.

L'invention a également pour objet, à titre de produits nouveaux, un substrat en phosphure d'indium obtenu par la mise en oeuvre de ce procédé et un composant à base d'un tel substrat.

Diverses autres caractéristiques ressortent de la description faite ci-dessous et illustrée par les dessins annexés.

## BREVE DESCRIPTION DES DESSINS :

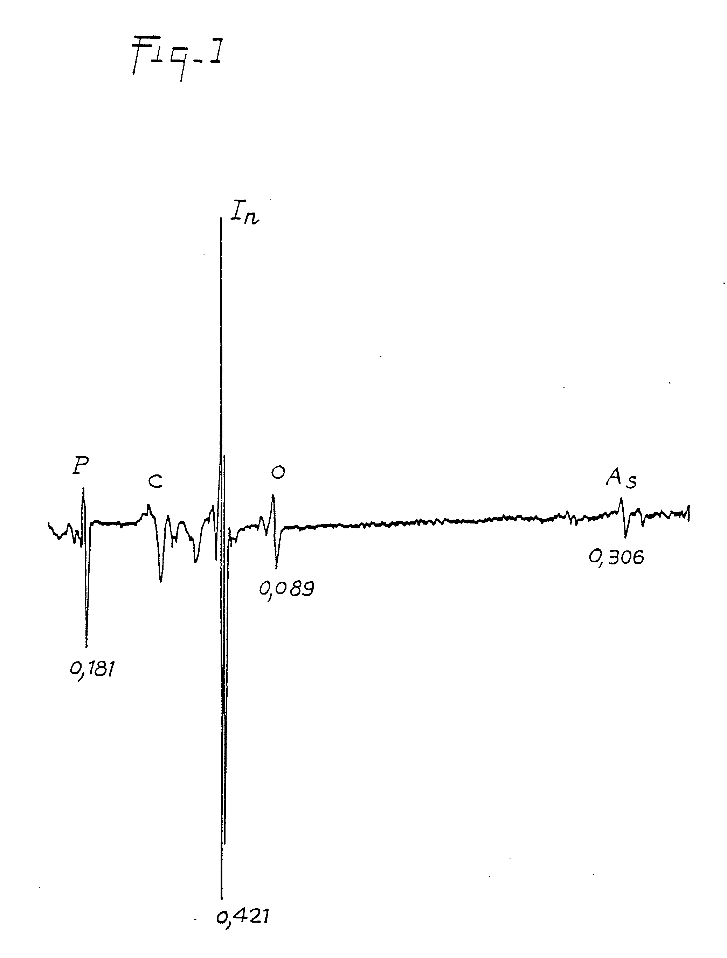

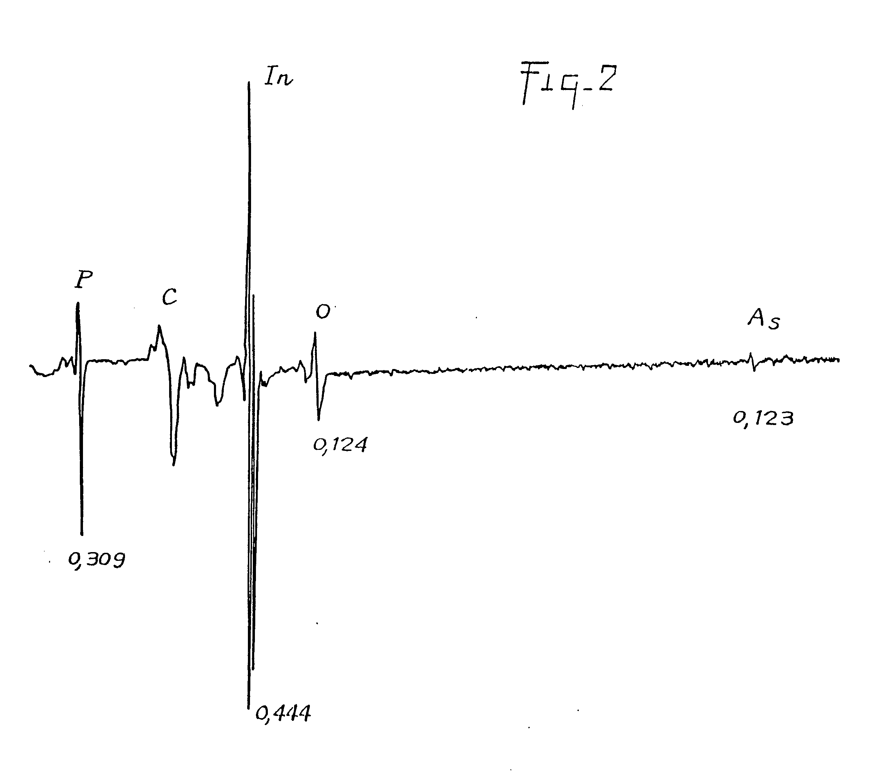

Les **fig. 1** et **2**, d'une part, et **3** et **4**, d'autre part, sont des courbes schématiques illustrant certaines caractéristiques d'un substrat en phosphure d'indium traité selon la méthode antérieure d'exposition en atmosphère d'arsenic sous ultra-vide et d'un substrat de même nature traité selon le procédé de l'invention.

## MEILLEURE MANIERE DE REALISER L'INVENTION :

Selon l'invention, le procédé de passivation en surface d'un substrat en phosphure d'indium consiste à soumettre la surface polie à traiter à un dégraissage par tout procédé connu convenant au phosphure d'indium et sans application d'ultrasons. Par exemple, un procédé de dégraissage convenant particulièrement bien consiste à utiliser des bains bouillants successifs de thichloroéthylène, d'acétone et de méthanol.

Une seconde étape du procédé, mise en oeuvre en cas de besoin et donc non impérativement selon le procédé, consiste à soumettre le substrat à une phase de décapage en vue d'éliminer la présence d'oxyde natif en surface.

A cette fin, une méthode envisageable consiste à tremper le substrat dans un bain de brome-méthanol maintenu à température ambiante. la composition de ce bain peut faire intervenir une proportion de brome comprise entre 0,1 et 1%. La phase de trempage se poursuit pendant une durée comprise entre 5 secondes et 3 minutes, puis le substrat est rincé abondamment avec du méthanol pur. Subsidiairement, un séchage du substrat sous un jet d'azote filtré peut intervenir.

Une autre méthode envisageable consiste à tremper le substrat dans une solution aqueuse d'acide fluorhydrique à 50% pendant une durée égale à 3 minutes. Le substrat est ensuite rincé abondamment à l'eau desionisée puis, éventuellement, séché sous azote filtré.

Une autre étape du procédé de l'invention consiste ensuite à tremper le substrat dans une solution aqueuse d'ions complexes d'arsenic ayant un pH inférieur à 4 et maintenue à une température comprise entre 0 et 50°C et, de préférence, située entre 10 et 25°C. La durée de trempage est comprise entre 30 secondes et 10 minutes et se trouve, plus particulièrement, avantageusement limitée entre 3 et 5 minutes.

Le trempage s'effectue, de préférence, dans l'obscurité et à tout le moins sans éclairement direct du substrat.

La solution aqueuse d'ions complexes d'arsenic peut être à base d'acide ortho-arsénique ($H_3AsO_4$) 34N ou une solution à base de sels d'arsenic.

En variante, la phase de trempage peut aussi faire intervenir l'application à la solution aqueuse d'un potentiel électrique variable en fonction du temps dans la plage de valeurs dans laquelle la solution ne provoque pas un dégagement gazeux.

A titre d'exemple, le potentiel électrique résultant dans le système comprenant une solution d'acide arsénique et un substrat d'InP, pourra être fixe ou varier successivement entre des valeurs se rapprochant de 1,4 V pour provoquer une réaction franche de la solution avec l'InP, puis des valeurs se rapprochant de −0,3 V pour provoquer la dissolution de la couche superficielle fournie par la réaction ci-dessus.

Après la phase de trempage, le substrat est soumis à un rinçage abondant à l'eau desionisée puis, éventuellement, séché sous un jet d'azote filtré.

Ce substrat ainsi traité se caractérise par un état de surface passivé, stable chimiquement et présentant une bonne résistance à la dégradation thermique sous vide jusqu'à des températures de surface avoisinant 450 à 480°C, toutes caractéristiques favorables au dépôt d'une couche isolante de toute nature. Un tel substrat se caractérise, par ailleurs, par une réduction de la densité des états de surface et une stabilisation des propriétés électroniques permettant de fabriquer, sur une telle base, des composants électroniques ou opto-électroniques performants ayant des caractéristiques satisfaisantes et stables dans le temps.

Ces avantages ci-dessus sont dus aux nouvelles caractéristiques physiques du substrat ainsi traité, lesquelles sont mises en évidence par spectrométrie d'électrons AUGER. La **fig. 1** montre un spectre d'électrons AUGER correspondant à un échantillon de phosphure d'indium traité sous ultra-vide en présence d'arsenic selon la méthode antérieure décrite précédemment alors que la **fig. 2** correspond à un échantillon traité selon l'invention. Dans ces spectres, les grandeurs portées en relation avec les pics identifiés correspondent à des valeurs relatives ramenées à la somme des composants représentée par l'ensemble des pics.

La comparaison de ces deux courbes permet de mettre en évidence, pour la seconde, une réduction notable de la hauteur du pic arsenic. Les expérimentations effectuées ont montré que le pic arsenic relatif correspondant à l'invention est toujours inférieur à 70% du pic arsenic relatif d'un substrat de même nature traité sous pression partielle d'arsenic.

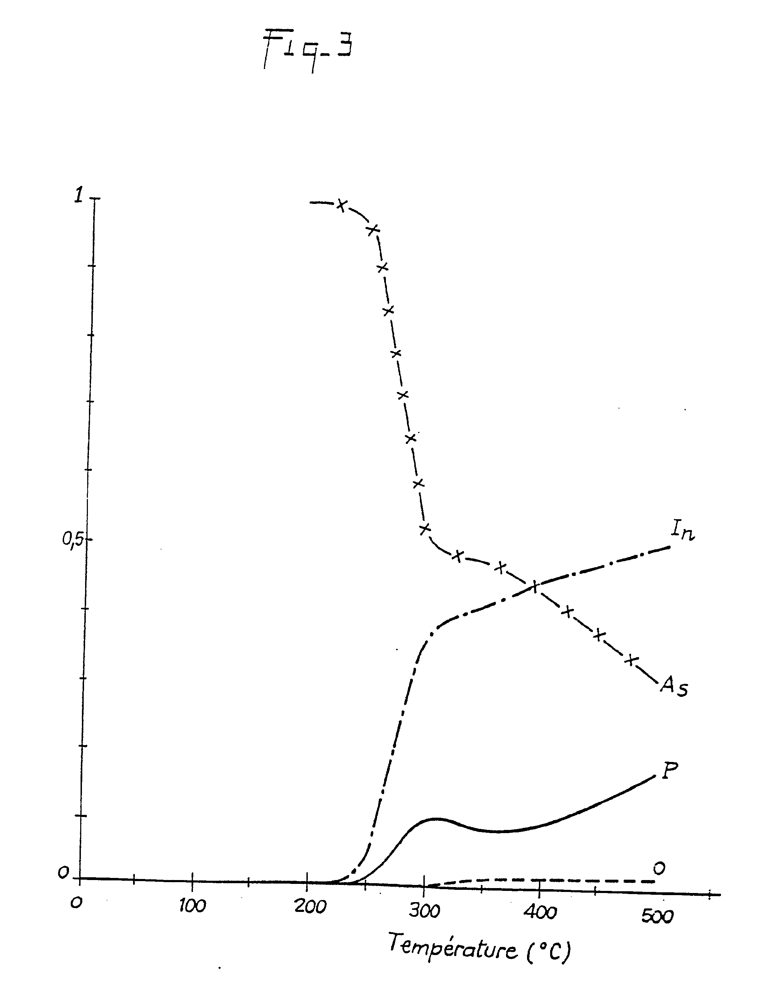

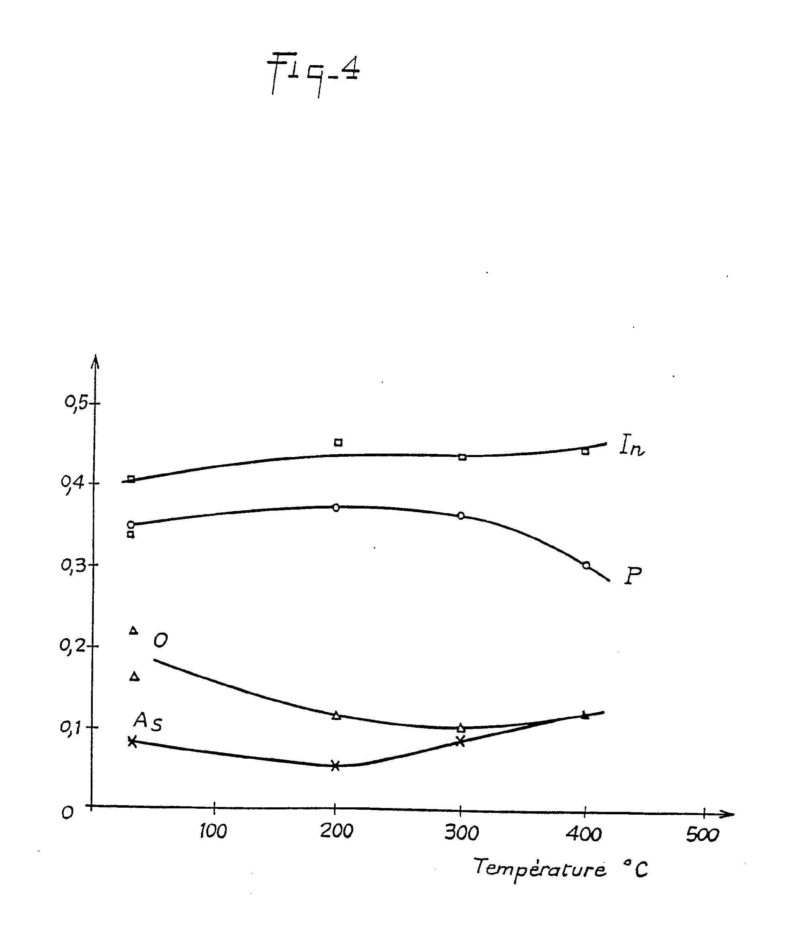

Les **fig. 3** et **4**, correspondant respectivement à deux échantillons traités respectivement selon la première méthode et selon l'invention, montrent l'évolution relative des pics AUGER indium (In), phosphore (P), oxygène (O) et arsenic (As) après chauffage à des températures croissantes et sous vide.

La comparaison de ces courbes met en évidence des variations de profils de courbes nettement distinctives. On remarque que les variations de pics en fonction de la température sont beaucoup plus importantes sur la **fig. 3** que sur la **fig. 4** correspondant à l'invention et pour laquelle on peut considérer qu'ils sont pratiquement constants. On peut noter, en particulier, que le pic arsenic selon la technique antérieure varie de façon appréciable dans toute la plage de températures et même d'une façon considérable avant 300°C.

Le procédé selon l'invention présente, ainsi que cela ressort de ce qui précède, l'avantage d'être simple de mise en oeuvre, de ne nécessiter qu'un matériel léger, peu coûteux et de pouvoir être conduit par un personnel non spécialement hautement qualifié.

En outre, ce procédé se caractérise par l'absence de chauffage de l'échantillon et par la possibilité de traitement localisé, ce qui permet sa mise en oeuvre à quelque stade que ce soit d'un processus de fabrication d'un composant électronique ou opto-électronique, sans provoquer de rediffusion d'impuretés due à un chauffage éventuel.

## POSSIBILITE D'APPLICATION INDUSTRIELLE :

L'invention est particulièrement adaptée à la fabrication des composants métal-isolant semi-conducteur.

## Revendications

1. Procédé de passivation en surface d'un substrat en phosphure d'indium, faisant intervenir la mise en présence d'arsenic, caractérisé en ce qu'il consiste à :
   - soumettre le substrat à un dégraissage sans application d'ultrasons,
   - tremper, pendant une durée comprise entre 30 secondes et 10 minutes, le substrat dans une solution aqueuse d'ions complexes d'arsenic, de pH inférieur à 4 et maintenue à une température comprise entre 0 et 50°C,
   - rincer abondamment le substrat à l'eau desionisée.

2. Procédé selon la revendication 1, caractérisé en ce que la solution est constituée par de l'acide ortho-arsènique.

3. Procédé selon la revendication 1, caractérisé en ce que la solution est constituée à base de sels d'arsenic.

4. Procédé selon l'une des revendications 1 à 3, caractérisé en ce que la solution est maintenue à une température comprise entre 10 et 25°C.

5. Procédé selon l'une des revendications 1 à 4, caractérisé en ce que la solution est soumise à un potentiel électrique.

6. Procédé selon la revendication 1, caractérisé en ce que le substrat est trempé pendant une durée comprise entre 3 et 5 minutes.

7. Procédé selon la revendication 1, caractérisé en ce que le substrat est trempé dans la solution en l'absence d'une source d'éclairement.

8. Procédé selon la revendication 1, caractérisé en ce que le substrat est soumis, après dégraissage, à un décapage visant à supprimer l'oxyde natif.

9. Procédé selon la revendication 8, caractérisé en ce que le décapage s'effectue par trempage dans un bain de brome-méthanol suivi par un rinçage au méthanol pur.

10. Procédé selon la revendication 8, caractérisé en ce que le décapage s'effectue par trempage dans une solution aqueuse d'acide fluorhydrique à 50% suivi par un rinçage à l'eau desionisée.

11. Produit comprenant un substrat de phosphure d'indium traité au moins localement lors d'une au moins de ses étapes de fabrication, conformément au procédé selon l'une des revendications 1 à 10, caractérisé par la présence d'un pic arsenic, mesuré par spectométrie **AUGER** appliquée à la partie traitée, inférieur à 70% de la valeur du plus petit pic arsenic d'un substrat de même nature traité sous pression partielle d'arsenic.

## Patentansprüche

1. Verfahren zur Oberflächenpassivierung eines Substrats aus Indiumphosphid, bei dem man von der Gegenwart von Arsen Gebrauch macht, dadurch gekennzeichnet, daß es darin besteht :
    — das Substrat einer Entfettung ohne Ultraschallanwendung zu unterwerfen,
    — während einer Dauer im Bereich von 30 Sekunden bis 10 Minuten das Substrat in eine wäßrige Lösung von komplexen Arsenionen eines pH-Werts unter 4 einzutauchen, die bei einer Temperatur von 0 bis 50°C gehalten wird,
    — das Substrat reichlich mit entionisiertem Wasser zu spülen.

2. Verfahren nach dem Anspruch 1, dadurch gekennzeichnet, daß die Lösung aus Orthoarsensäure besteht.

3. Verfahren nach dem Anspruch 1, dadurch gekennzeichnet, daß die Lösung auf Basis von Arsensalzen zusammengesetzt ist.

4. Verfahren nach einem der Ansprüche 1 bis 3, dadurch gekennzeichnet, daß die Lösung auf einer Temperatur im Bereich von 10 bis 25°C gehalten wird.

5. Verfahren nach einem der Ansprüche 1 bis 4, dadurch gekennzeichnet, daß die Lösung einem elektrischen Potential ausgesetzt wird.

6. Verfahren nach dem Anspruch 1, dadurch gekennzeichnet, daß das Substrat während einer Dauer von 3 bis 5 Minuten eingetaucht wird.

7. Verfahren nach dem Anspruch 1, dadurch gekennzeichnet, daß das Substrat in die Lösung in der Abwesenheit einer Beleuchtungsquelle eingetaucht wird.

8. Verfahren nach dem Anspruch 1, dadurch gekennzeichnet, daß das Substrat nach Entfettung einem Beizen zwecks Beseitigung der Eigenoxidhaut unterworfen wird.

9. Verfahren nach dem Anspruch 8, dadurch gekennzeichnet, daß das Beizen durch Eintauchen in ein Brom-Methanol-Bad mit nachfolgendem Spülen mittels reines Methanols erfolgt.

10. Verfahren nach dem Anspruch 8, dadurch gekennzeichnet, daß das Beizen durch Eintauchen in eine wäßrige 50%-ige Fluorwasserstoffsäurelösung mit nachfolgendem Spülen mittels entionisierten Wassers erfolgt.

11. Erzeugnis mit einem Indiumphosphidsubstrat, das wenigstens örtlich während wenigstens eines seiner Herstellungsschritte gemäß dem Verfahren nach einem der Ansprüche 1 bis 10 behandelt wurde, gekennzeichnet durch das Vorliegen eines durch auf den behandelten Teil angewandte AUGER-Spektrometrie gemessenen Arsenpeaks unter 70% des Wertes des kleinsten Arsenpeaks eines unter Arsenpartialdruck behandelten Substrats gleicher Art.

## Claims

1. Process for surface passivation of an indium phosphide substrate employing the presence of arsenic, characterized in that it consists in :
    — subjecting the substrate to cleaning without application of ultrasounds,
    — soaking, for a duration of between 30 seconds and 10 minutes, the substrate in an aqueous solution of complex arsenic ions maintained at a temperature of between 0 and 50°C,
    — abundantly rinsing the substrate in deionized water.

2. Process according to claim 1, characterized in that the solution is constituted by orthoarsenic acid.

3. Process according to claim 1, characterized in that the solution is constituted on the basis of arsenic salts.

4. Process according to one of claims 1 to 3, characterized in that the solution is maintained at a temperature of between 10 and 25°C.

5. Process according to one of claims 1 to 4, characterized in that the solution is subjected to an electrical potential.

6. Process according to claim 1, characterized in that the substrate is soaked for a duration of between 3 and 5 minutes.

7. Process according to claim 1, characterized in that the substrate is soaked in the solution in the absence of a source of illumination.

8. Process according to claim 1, characterized in that the substrate is subjected, after cleaning, to pickling aiming at eliminating the native oxide.

9. Process according to claim 8, characterized in that pickling is effected by soaking in a bath of bromine-methanol followed by rinsing in pure methanol.

10. Process according to claim 8, characterized in that pickling is effected by soaking in a 50% aqueous hydrofluoric acid solution followed by rinsing in deionized water.

11. Product comprising an indium phosphide substrate treated at least locally during at least one of its manufacturing steps, in accordance with the process according to one of claims 1 to 10, characterized, by the presence of an arsenic peak, measured by AUGER spectrometry applied to the treated part, less than 70% of the arsenic peak of a substrate of the same nature treated under partial pressure of arsenic.

# Fig-1

Fig-2

EP 0 261 190 B1

Fig.3

Fig-4